# EUROPÄISCHE PATENTSCHRIFT

(11) **EP 3 008 520 B1**
(45) Veröffentlichungstag und Bekanntmachung des Hinweises auf die Patenterteilung: **09.08.2017**
(21) Anmeldenummer: 14729893.9
(22) Anmeldetag: 12.06.2014
(51) Int. Cl.: G03F 7/18

(54) **VERFAHREN ZUR HERSTELLUNG VON ZYLINDRISCHEN FLEXODRUCKELEMENTEN**
METHOD FOR MANUFACTURING CYLINDRICAL FLEXO-PRINTING COMPONENTS
PROCÉDÉ DE FABRICATION D'ÉLÉMENTS D'IMPRESSION FLEXOGRAPHIQUE CYLINDRIQUES

(30) Priorität: 14.06.2013 EP 13172045
(43) Veröffentlichungstag der Anmeldung: 20.04.2016
(73) Patentinhaber: Flint Group Germany GmbH, 70469 Stuttgart (DE)
(72) Erfinder: STEBANI, Uwe, 67592 Flörsheim-Dalsheim (DE); BEDAT, Joelle, F-67850 Offendorf (FR); BECKER, Armin, 67259 Großniedesheim (DE); LEINENBACH, Alfred, 77704 Oberkirch-Nußbach (DE); MAY, Claudia, 77731 Willstätt (DE); ARNOLD, Christian, 77694 Kehl Goldscheuer (DE); ROTHEN, Josef, 42699 Solingen (DE)
(74) Vertreter: Schuck, Alexander
(86) Internationale Anmeldenummer: PCT/EP2014/062195
(87) Internationale Veröffentlichungsnummer: WO 2014/198810

(56) Entgegenhaltungen:
- EP-A1- 1 642 715
- EP-A2- 0 084 851
- EP-A2- 0 185 337
- EP-A2- 0 362 641
- EP-A2- 1 076 263
- US-A- 5 798 019
- US-A1- 2004 067 438

## Beschreibung

Die vorliegende Erfindung betrifft ein Verfahren zur Herstellung von zylindrischen Flexodruckelementen, die zur Herstellung von zylindrischen Flexodruckformen genutzt werden können, wobei die zylindrischen Flexodruckelemente eine reliefbildende Schicht aufweisen, und wobei man zur Herstellung der reliefbildenden Schicht mehrere Schichten eines schmelzflüssigen, reliefbildenden Materials, bevorzugt eines schmelzflüssigen, fotopolymerisierbaren Materials in einem kontinuierlichen Verfahren nacheinander auf eine rotierende zylindrische Hülse aufbringt.

Flexodruckformen können Plattenform oder Zylinderform aufweisen. Flexodruckplatten werden zum Drucken üblicherweise auf den Druckzylinder aufgeklebt. Es ist also nur ein Teil des Druckzylinders mit der Flexodruckplatte bedeckt.

Aus wirtschaftlichen Gründen werden immer höhere Druckgeschwindigkeiten angestrebt. Mit zunehmender Druckgeschwindigkeit treten beim Drucken mit Platten sowohl Probleme mit Schwingungen der Druckmaschine als auch Druckprobleme an den Druckplattenkanten auf. Höhere Druckgeschwindigkeiten, insbesondere Geschwindigkeiten von mehr als 300 m/min erfordern daher zylindrische Flexodruckformen, auch Runddruckformen genannt, so dass der Druckzylinder im gesamten Umfange mit einer Druckschicht umgeben ist. Zylindrische Druckformen besitzen weiterhin große Bedeutung für den Druck von Endlos-Mustern wie beispielsweise Tapeten, Dekorpapieren oder Geschenkpapieren sowie für Druckaufträge, bei denen eine sehr hohe Registergenauigkeit gefordert ist.

Zylindrische Flexodruckformen umfassen üblicherweise eine zylindrische, dimensionsstabile Basishülse, auch "Sleeve" genannt, welche mit einer Druckschicht versehen wurde. Die zylindrischen Flexodruckformen können zum Druck in prinzipiell bekannter Art und Weise auf Luftzylinder der Druckmaschine montiert werden. Luftzylinder sind spezielle Druckzylinder, welche über einen Druckluftanschluss an der Stirnseite verfügen, mit dem Druckluft in das Innere des Zylinders geleitet werden kann. Von dort aus kann sie über an der Außenseite des Zylinders angeordnete Löcher wieder austreten. Zur Montage eines Sleeves wird Druckluft in den Luftzylinder eingeleitet und tritt an den Austrittslöchern wieder aus. Der Sleeve kann nun auf den Luftzylinder aufgeschoben werden, weil er sich unter dem Einfluss des Luftkissens geringfügig dehnt und das Luftkissen die Reibung deutlich vermindert. Wenn die Druckluftzufuhr beendet wird, geht die Dehnung zurück und der Sleeve sitzt auf der Oberfläche des Luftzylinders fest. Weitere Einzelheiten zur Sleeve-Technik sind beispielsweise offenbart in "Technik des Flexodrucks", S. 73 ff., Coating Verlag, St. Gallen, 1999.

Qualitativ hochwertige Runddruckformen können nicht hergestellt werden, indem man eine Hülse einfach mit einer bereits druckfertig verarbeiteten Flexodruckplatte vollständig umhüllt. An den zusammenstoßenden Enden der Druckplatte verbleibt oftmals ein feiner Spalt, welcher bei echten Endlos-Motiven oder versetztem Nutzen immer auch druckende Bereiche der Platte durchschneidet. Dieser Spalt führt zu einer deutlich sichtbaren Linie im Druckbild. Um diese Linie zu vermeiden, dürfen sich an dieser Stelle nur nicht druckende Vertiefungen befinden, und somit können nicht beliebige Muster gedruckt werden. Außerdem besteht bei dieser Technik die Gefahr, dass das in der Druckfarbe enthaltene Lösungsmittel in den Spalt eindringen und die Enden der Druckplatte vom Druckzylinder loslösen kann. Dies führt zu noch stärkeren Störungen im Druckbild. Auch bei einem Verkleben der Enden verbleiben noch deutlich sichtbare Spuren im Druckbild.

Zur Herstellung qualitativ hochwertiger Runddruckformen ist es daher erforderlich, den Druckzylinder oder eine Hülse mittels geeigneter Techniken mit einer vollständig umhüllenden, reliefbildenden Schicht zu versehen. Dies kann beispielsweise durch Beschichten aus Lösung oder durch Ringextrusion erfolgen. Beide Techniken sind jedoch äußerst aufwändig und daher entsprechend teuer.

Die Fertigung runder, fotopolymerisierbarer Flexodruckelemente erfolgt häufig, indem man ein plattenförmiges, fotopolymerisierbares Flexodruckelement auf eine zylindrische Basishülse auflegt und anschließend durch Erhitzen die Enden der Platte miteinander verschmilzt. Anschließend wird die beschichtete Hülse geschliffen und auf Toleranz gebracht. Dies ist ein zeitaufwändiger Prozess. Schließlich kann eine laserablatierbare Maskenschicht (LAMS Layer) aufgebracht werden. Derartige runde Flexodruckelemente sind daher teuer und haben lange Lieferzeiten.

WO 2004/092841 schlägt ein Verfahren zur Herstellung von zylindrischen, fotopolymerisierbaren Flexodruckelementen vor, bei dem die Schichtenden eines geeignet zurechtgeschnittenen, plattenförmigen Flexodruckelementes durch Kalandrieren unter Erwärmen auf eine Temperatur unterhalb der Schmelztemperatur verbunden werden, wobei das Zurechtschneiden nicht mittels eines senkrechten Schnitts, sondern mittels eines Gehrungsschnitts erfolgt. Ein Schleifprozess ist nicht erforderlich. Es sind aber sehr lange Kalandrierzeiten erforderlich, um zufriedenstellende Ergebnisse zu erreichen.

US 5,916,403 offenbart ein Verfahren, bei dem ein Schmelzestrang eines fotopolymerisierbaren Materials unter Kalandrieren mit einem oder mehreren Kalandern auf eine Hülse aufgebracht wird. Um eine vollständige Beschichtung der Hülse zu erreichen, wird die Hülse während des Kalandrierens und des Aufbringens des Schmelzestranges gedreht und zusätzlich in axialer Richtung bewegt. Das Aufbringen der fotopolymerisierbaren Schicht erfolgt also in Form einer Schraubenlinie. Für diese Technik ist eine äußerst aufwändige Apparatur erforderlich. Außerdem können durch das Kalandrieren des Schmelzestranges Luftblasen in der Schicht eingeschlossen werden, oder es kann partikuläres Material in die Schicht eingezogen werden. Die Oberflächengüte der gefertigten zylinderförmigen Flexodruckelemente wird dadurch beeinträchtigt und die Ausbeute des Verfahrens wird reduziert.

Eine Aufgabe der Erfindung war es, ein Verfahren zur Herstellung von Flexodruckelementen, bevorzugt fotopolymerisierbaren Flexodruckelementen bereit zu stellen, welches Flexodruckelemente mit einer hohen Oberflächenqualität liefert, ohne dass ein Nachbearbeiten der Oberfläche erforderlich ist.

Diese Aufgabe wird durch ein Verfahren gemäß den Patentansprüchen gelöst. Dementsprechend wurde ein Verfahren zur Herstellung von zylindrischen Flexodruckelementen mindestens umfassend eine zylindrische Hülse (3) sowie eine reliefbildende Schicht gefunden, wobei man zum Aufbringen der reliefbildenden Schicht eine Vorrichtung (V) verwendet, welche mindestens die folgenden Komponenten umfasst:
- eine Haltevorrichtung (1) zur drehbaren Lagerung der zylindrischen Hülse (3),
- eine Antriebeinheit, mit der die zylindrische Hülse (3) in Rotation um die Längsachse versetzt werden kann,
- eine Aufbringvorrichtung (4) zum flächigen Auftragen eines schmelzflüssigen, reliefbildenden Materials auf die zylindrische Hülse (3),
und wobei das Verfahren mindestens die folgenden Verfahrensschritte umfasst:
(A) Bereitstellen einer Schmelze eines reliefbildenden Materials,
(B) Versetzen der zylindrischen Hülse (3) in Rotation um die Längsachse,
(C) flächiges Auftragen des schmelzflüssigen, reliefbildenden Materials auf die rotierende zylindrische Hülse (3) mittels der Vorrichtung (4), wobei sich eine Schicht des reliefbildenden Materials auf der zylindrischen Hülse (3) bildet, mit der Maßgabe, dass die zylindrische Hülse während des Beschichtungsvorganges mindestens zwei vollständige Umdrehungen vollführt, so dass mindestens zwei Schichten des reliefbildenden Materials aufeinander beschichtet werden, wobei der Abstand der Vorrichtung (4) und der jeweils letzten aufgebrachten Schicht des reliefbildenden Materials während des Beschichtens konstant gehalten wird und somit entsprechend der zunehmenden Gesamtschichtdicke der Abstand zwischen der Vorrichtung (4) und der zylindrischen Hülse (3) erhöht wird.

Verzeichnis der Abbildungen:
- Abbildung 1: Schematische Darstellung des erfindungsgemäßen Verfahrens
- Abbildung 2: Schematische Darstellung einer bevorzugten Ausführungsform des erfindungsgemäßen Verfahrens unter Verwendung einer Apparatur mit Kalanderwalze
- Abbildung 3: Schematische Darstellung einer bevorzugten Ausführungsform des erfindungsgemäßen Verfahrens unter Verwendung einer Apparatur mit Kalanderwalze sowie zusätzlicher Kühl- bzw. Stützwalze.
- Abbildung 4: Seitenansicht einer mit 3 Lagen reliefbildenden Materials beschichteten zylindrischen Hülse einschließlich einer aufsteigenden Rampe beim Anfahren der Beschichtung und einer absteigenden Rampe zum Schluss der Beschichtung.

Zur Erfindung ist im Einzelnen das Folgende auszuführen:
Die mittels des erfindungsgemäßen Verfahrens herstellbaren zylindrischen, Flexodruckelemente umfassen in prinzipiell bekannter Art und Weise mindestens eine zylindrische Hülse (3) sowie eine reliefbildende Schicht. Sie können darüber hinaus noch weitere Schichten umfassen.

Der Begriff "Flexodruckelement" steht in prinzipiell bekannter Art und Weise für ein Ausgangsmaterial, welches zu druckfertigen Flexodruckformen verarbeitet werden kann. Flexodruckformen weisen eine mit einen Druckrelief versehene elastomere Schicht auf. Flexodruckelemente weisen noch kein Relief auf, sondern eine sogenannte reliefbildende Schicht, welche erst in weiteren Schritten zu einem Druckrelief verarbeitet werden kann. Geeignete Verfahren zur Herstellung von Flexodruckformen aus Flexodruckelementen sind dem Fachmann bekannt.

In einer bevorzugten Ausführungsform des Verfahrens handelt es sich um eine fotopolymerisierbare, reliefbildende Schicht, weitere Ausführungsformen werden in den Patentansprüchen beschrieben.

### Aufbau der herzustellenden Flexodruckelemente

Die zylindrische Hülse (3) dient als Basis zum Aufbringen der reliefbildenden Schicht, bevorzugt der fotopolymerisierbaren, reliefbildenden Schicht sowie gegebenenfalls weiterer Schichten. Derartige Hülsen werden auch als Sleeves bezeichnet und sind in einer Vielzahl von Ausführungsformen kommerziell erhältlich. Die Länge der Hülse kann vorzugsweise 200 mm bis 4000 mm und der Durchmesser vorzugsweise 40 mm bis 600 mm betragen. Die Wandstärke kann je nach Ausführungsform beispielsweise 1 bis 160 mm betragen. Geeignete Hülsen weisen häufig einen mehrschichtigen Aufbau auf und können beispielsweise Schichten aus Polyester, Polyacrylat oder Epoxidharz umfassen, wobei die Schichten üblicherweise mit Gewebefasern oder Fasermatten verstärkt sind.

Bevorzugte Hülsen bei fotopolymerisierbaren Flexodruckelementen sind transparent für UV-Licht, so dass die fotopolymerisierbaren Flexodruckelemente vor der Verarbeitung zu einer runden Flexodruckform von der Rückseite vorbelichtet werden können.

Die reliefbildende Schicht kann unmittelbar auf der zylindrischen Hülse (3) aufgebracht sein. In einer weiteren Ausführungsform der Erfindung können zwischen der zylindrischen Hülse und der reliefbildenden Schicht eine oder mehrere zusätzliche Schichten angeordnet sein. Beispiele derartiger Schichten umfassen Haft- oder Klebeschichten, Schaumschichten oder elastomere Unterschichten.

Zur Herstellung der reliefbildenden Schicht werden thermoplastische Materialien eingesetzt. Die Zusammensetzung der reliefbildenden Schicht richtet sich je nach der vorgesehenen Verarbeitung des Flexodruckelements.

Ist eine Verarbeitung mittels Fotopolymerisation vorgesehen, umfasst das zylindrische Flexodruckelement eine fotopolymerisierbare, reliefbildendende Schicht. Fotopolymerisierbare Schichten können bildmäßig belichtet werden. Anschließend werden die nicht belichteten Anteile der Schicht entfernt, beispielsweise unter Verwendung von geeigneten Lösemitteln. Sie können auch vollflächig belichtet werden, und anschließend kann in die so erhaltene elastomere Schicht ein Druckrelief mittels Lasern eingraviert werden.

Die fotopolymerisierbare, reliefbildende Schicht ist vorzugsweise thermoplastisch und es können prinzipiell die üblichen, zur Herstellung von Flexodruckelementen geeigneten thermoplastischen Zusammensetzungen eingesetzt werden. Derartige Zusammensetzungen umfassen thermoplastisch-elastomere Bindemittel, wie beispielsweise Styrol-Butadien-Blockcopolymere, Styrol-Isopren-Blockcopolymere, Polybutadien, Ethylen-Propylen-Dien-Kautschuke oder extrudierbare Rohgummis, Fotoinitiatoren, vernetzbare Komponenten sowie optional weitere Komponenten.

In einer bevorzugten Ausführungsform der Erfindung umfasst die fotopolymerisierbare, reliefbildendende Schicht mindestens ein thermoplastisch-elastomeres Blockcopolymer, mindestens ein ethylenisch ungesättigtes Monomer, mindestens einen Fotoinitiator, mindestens einen Weichmacher sowie optional weitere Komponenten.

Die thermoplastisch-elastomeren Blockcopolymere umfassen mindestens einen Block, welcher im Wesentlichen aus Alkenylaromaten besteht und mindestens einen Block, welcher im Wesentlichen aus 1,3-Dienen besteht. Bei den Alkenylaromaten kann es sich beispielsweise um Styrol, α-Methylstyrol oder Vinyltoluol handeln. Bevorzugt handelt es sich um Styrol. Bei den 1,3-Dienen handelt es sich bevorzugt um Butadien und/oder Isopren. Bei diesen Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock. Selbstverständlich können auch Gemische mehrerer thermoplastisch-elastomerer Bindemittel eingesetzt werden, vorausgesetzt, die Eigenschaften der reliefbildenden Schicht werden dadurch nicht negativ beeinflusst.

Neben den genannten thermoplastisch-elastomeren Blockcopolymeren kann die fotopolymerisierbare Schicht auch noch weitere, von den Blockcopolymeren verschiedene elastomere Bindemittel umfassen. Mit derartigen zusätzlichen Bindemitteln, auch sekundäre Bindemittel genannt, lassen sich die Eigenschaften der fotopolymerisierbaren Schicht modifizieren. Ein Beispiel für ein sekundäres Bindemittel sind Vinyltoluol-α-Methylstyrol-Copolymere. Im Regelfalle sollte die Menge derartiger sekundärer Bindemittel 25 Gew.-% bezüglich der Gesamtmenge aller eingesetzten Bindemittel nicht überschreiten. Bevorzugt übersteigt die Menge derartiger sekundärer Bindemittel nicht 15 Gew. %, besonders bevorzugt nicht 10 Gew.-%.

Die Gesamtmenge an Bindemitteln beträgt üblicherweise 40 bis 90 Gew.-% bezüglich der Summe aller Bestandteile der reliefbildenden Schicht, bevorzugt 50 bis 90 Gew.-% und besonders bevorzugt 60 bis 85 Gew.-%.

Die eingesetzten ethylenisch ungesättigten Monomere sollten mit den Bindemitteln verträglich sein und weisen mindestens eine polymerisierbare, ethylenisch ungesättigte Gruppe auf. Als Monomere können insbesondere Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure und Allylverbindungen eingesetzt werden. Bevorzugt sind Ester der Acrylsäure oder Methacrylsäure. Bevorzugt sind 1,4-Butandioldiacrylat, 1,6-Hexandioldiacrylat, 1,6-Hexandioldimethacrylat, 1,9-Nonandioldiacrylat oder Trimethylolpropantri(meth)acrylat. Selbstverständlich können Gemische verschiedener Monomere eingesetzt werden.

Bevorzugt umfasst, - bzw. beinhaltet als Baustein - die reliefbildende Schicht mindestens ein ethylenisch ungesättigtes Monomer mit zwei ethylenisch ungesättigten Gruppen, insbesondere 1,6-Hexandioldiacrylat und/oder 1,6-Hexandioldimethacrylat. Die Gesamtmenge aller eingesetzten Monomere in der reliefbildenden Schicht zusammen beträgt in der Regel 1 bis 20 Gew.-%, bevorzugt 5 bis 20 Gew.-%, jeweils bezogen auf die Summe aller Bestandteile der reliefbildenden Schicht. Die Menge von Monomeren mit zwei ethylenisch ungesättigten Gruppen beträgt bevorzugt 5 bis 20 Gew.-%, bezogen auf die Summe aller Bestandteile der reliefbildenden Schicht, besonders bevorzugt 8 bis 18 Gew.-%.

Beispiele für geeignete Fotoinitiatoren bzw. Fotoinitiatorsysteme umfassen Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-%, bevorzugt 1 bis 4 Gew.-% und besonders bevorzugt 1,5 bis 3 Gew.-%, bezogen auf die Menge (Gewicht) aller Bestandteile der reliefbildenden Schicht.

Beispiele für Weichmacher umfassen paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, insbesondere solche mit einem mittleren Molekulargewicht zwischen 500 und 5000 g/mol, oder flüssige oligomere AcrylnitrilButadien-Copolymere oder oligomere Ethylen-Propylen-Dien-Copolymere.

Die Menge aller Weichmacher im Flexodruckelement beträgt in der Regel 1 bis 40 Gew.-% und bevorzugt 1 bis 20 Gew.-%. Die Menge der Weichmacher richtet sich auch nach dem jeweiligen Bindemittelsystem. Bei Platten auf Basis eines Styrol-Isopren-Bindemittelsystems haben sich Weichmachermengen von 1 bis 10 Gew.-% bewährt. Bei Platten auf Basis eines Styrol-Butadien-Bindemittelsystems haben sich Weichmachermengen von 20 bis 40 Gew.-% bewährt.

Die fotopolymerisierbare, reliefbildende Schicht kann weiterhin typische Additive und Zusatzstoffe enthalten. Beispiele derartiger Zusatzstoffe und Additive umfassen Farbstoffe, Inhibitoren für die thermische Polymerisation, Füllstoffe oder Antioxidation. Der Fachmann trifft je nach den gewünschten Eigenschaften der Schicht eine entsprechende Auswahl. Die Menge derartiger Zusatzstoffe sollte aber im Regelfalle 10 Gew. % bezogen auf die Menge aller Komponenten der reliefbildenden Schicht, bevorzugt 5 Gew. % nicht überschreiten.

Der Fachmann wählt je nach den gewünschten Eigenschaften der Flexodruckform eine geeignete Zusammensetzung der fotopolymerisierbaren, reliefbildenden Schicht aus.

Flexodruckelemente, welche mittels Lasergravur zu Flexodruckformen verarbeitet werden sollen, können auch eine fotopolymerisierbare reliefbildende Schicht der beschriebenen Zusammensetzung aufweisen. Die Schicht kann hierbei auch zusätzliche Füllstoffe enthalten, welche die Fotopolymerisation mit UV- bzw. UV/VIS-Strahlung nicht stören, wie beispielsweise feinteiliges Siliciumdioxid.

Für Flexodruckelemente zur Lasergravur kommen aber auch noch reliefbildende Schichten anderer Zusammensetzung in Frage.

Sofern die Vernetzung nicht mit UV- bzw. UV/VIS-Strahlung erfolgen soll, sondern mit Elektronenstrahlung, muss die reliefbildende Schicht nicht mehr optisch transparent sein. Derartige Flexodruckelemente können neben den genannten Komponenten insbesondere die Strahlung von IR-Lasern stark absorbierende Farb- bzw. Füllstoffe umfassen. Beispielsweise kann die Schicht feinteiligen Ruß enthalten.

Die reliefbildenden Schichten von zur Lasergravur vorgesehenen Flexodruckelementen müssen auch nicht zwingend vernetzt werden, sondern können neben thermoplastisch-elastomeren Bindemittel zum Erreichen einer ausreichenden mechanischen Festigkeit eine geeignete Menge Füllstoffe enthalten. Für derartige Flexodruckelemente kann ebenfalls Ruß als Füllstoff eingesetzt werden.

Zur Ausführung des erfindungsgemäßen Verfahrens hat es sich bewährt, ein thermoplastisches Material einzusetzen, welches in geschmolzenem Zustand eine Schmelzviskosität im Bereich von 10 Pas bis 1000 Pas, bevorzugt von 50 Pas bis 200 Pas aufweist. Die Schmelzviskosität (nach gängigen Verfahren ermittelt) gemessen bei einer bestimmten Temperatur hängt naturgemäß von der gewählten Zusammensetzung des thermoplastischen Materials ab. Die Viskosität kann durch Wahl einer geeigneten Temperatur im Bereich von 80°C bis 180°C auf die gewünschte Viskosität eingestellt werden.

Das zylindrische Flexodruckelement kann optional auf der reliefbildenden Schicht, insbesondere einer fotopolymerisierbaren, reliefbildenden Schicht weitere Schichten aufweisen.

Beispielsweise können sich auf fotopolymerisierbaren, reliefbildenden Schichten transparente Deck- und/oder Barriereschichten befinden. Derartige Schichten können beispielsweise zur Entklebung von reliefbildenden, fotopolymerisierbaren Schicht dienen oder dazu, das Eindringen von Luftsauerstoff in die fotopolymerisierbare Schicht zu verhindern oder zumindest zu verlangsamen. Derartige Schichten können beispielsweise elastomere Polyamide oder teilkristalline Polyvinylalkohole umfassen.

Optional können fotopolymerisierbare, zylindrische Flexodruckelemente weiterhin eine laserablatierbare Maskenschicht aufweisen. Diese kann direkt auf der fotopolymerisierbaren, reliefbildenden Schicht angeordnet sein. Zwischen der laserablatierbaren Maskenschicht und der fotopolymerisierbaren, reliefbildenden Schicht können sich aber optional auch weitere Schichten befinden, beispielsweise die bereits genannte transparente Deck- oder Barriereschicht. Laserablative Maskenschichten sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die laserablatierbare Schicht kann mittels eines IR-Lasers eine Maske eingeschrieben werden, d.h. die Schicht wird an den Stellen, an denen sie vom Laserstrahl getroffen wird, zersetzt und abgetragen. Beispiele für die Bebilderung von Flexodruckelementen mit IR-ablativen Masken sind beispielsweise in EP-A 0 654 150 oder EP-A 1 069 475 offenbart.

### Erfindungsgemäßes Verfahren

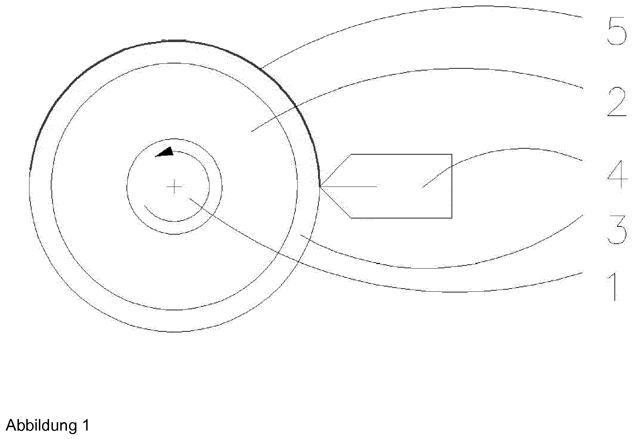

Das Prinzip des erfindungsgemäßen Verfahrens ist schematisch in Abbildung 1 dargestellt.

Zur Ausführung des erfindungsgemäßen Verfahrens wird eine Vorrichtung (V) eingesetzt, die ebenfalls Gegenstand der Erfindung ist.

Diese umfasst mindestens eine Haltevorrichtung (1) zur drehbaren Lagerung der zylindrischen Hülse (3). Bei der Haltevorrichtung kann es sich beispielsweise um einen drehbar gelagerten Dorn handeln. Die zylindrische Hülse (3) kann zur Ausführung des Verfahrens unmittelbar auf den Dorn montiert werden. Vorteilhaft kann auf den Dorn aber auch zunächst eine sogenannte Adapterhülse (3) bzw. ein Adaptersleeve montiert werden. Mit einer solchen Adapterhülse lässt sich der Durchmesser des Dorns entsprechend dem Durchmesser der zylindrischen Hülse (3) vergrößern. Die Adapterhülsen können aus Stahl gefertigt sein.

Um einen schnellen Wechsel von einem Umfang zum nächsten zu realisieren, und um eine einfachere Handhabung zu ermöglichen, können auch leichtere PUR / GFK Adapter eingesetzt werden, wie sie auch später in der Druckmaschine verwendet werden können. Die zu beschichtende zylindrische Hülse (3) hat üblicherweise einen geringeren Innendurchmesser als der Außendurchmesser der Adapterhülse (2). Dieses Untermaß liegt üblicherweise im Bereich < 1 mm und hängt auch vom absoluten Durchmesser der Hülse ab. Die zylindrische Hülse (3) kann auf die Adapterhülse (2) aufgezogen werden, indem man die Adapterhülse (2) in prinzipiell bekannter Art und Weise mit Druckluft beaufschlagt, welche über feine Öffnungen in der Oberfläche der Adapterhülse ausströmen kann. Unter dem Einfluss dieses Luftkissens lässt sich die zylindrische Hülse (3) auf die Adapterhülse (2) aufziehen. Nach Abschalten der Druckluft klemmt die zylindrische Hülse (3) auf der Adapterhülse (2) fest.

Die Vorrichtung (V) umfasst weiterhin eine Antriebseinheit, mit der die Haltevorrichtung mitsamt der zylindrischen Hülse (3) sowie gegebenenfalls einer Adapterhülse (2) in Rotation um die Längsachse versetzt werden kann.

Die verwendete Vorrichtung (V) umfasst weiterhin eine Aufbringvorrichtung (4) zum flächigen Auftragen eines schmelzflüssigen, reliefbildenden Materials auf die zylindrische Hülse (3), so dass sich eine Schicht des reliefbildenden Materials auf der Hülse ausbildet. Bevorzugt wird ein reliefbildendes, fotopolymerisierbares Material aufgebracht.

Die Vorrichtung (V) kann auch zwei oder mehrere Aufbringvorrichtungen (4) umfassen. Eine solche Vorrichtung kann dazu genutzt werden, um unterschiedliche schmelzflüssige Materialien nacheinander aufzubringen.

Bei der Aufbringvorrichtung (4) kann es sich prinzipiell um jede Art von Vorrichtung handeln, welche zum flächigen Auftrag eines schmelzflüssigen Materials geeignet ist, so dass eine Schicht des Materials auf der zylindrischen Hülse (3) gebildet wird. Beispiele geeigneter Aufbringvorrichtungen (4) umfassen Schlitzdüsen, Breitschlitzdüsen oder Mehrkanalschlitzdüsen. Die Beschichtungseinheit kann vertikal oder unter einem anderen Winkel in Bezug auf die Oberfläche der zylindrischen Hülse (3) angebracht werden. Sofern eine nicht horizontale oder vertikale Anordnung gewählt wird, handelt es sich bevorzugt um eine Anordnung bei einem Winkel zwischen horizontaler und vertikaler Anordnung. Die Aufbringvorrichtung (4) ist in aller Regel so gelagert, dass deren Abstand zur zylindrischen Hülse (3) variiert werden kann.

Es ist empfehlenswert, Aufbringvorrichtungen (4) einzusetzen, welche eine variable Beschichtungsbreite aufweisen. Bei Verwendung derartiger Aufbringvorrichtungen können mit der Vorrichtung (V) vorteilhaft auch unterschiedlich lange Hülsen beschichtet werden. Bei einer Aufbringvorrichtung mit variabler Beschichtungsbreite kann es sich beispielsweise um eine Mehrkanaldüse handeln, deren einzelne Kanäle separat an- und abgeschaltet werden können oder um eine in der Breite verstellbare Schlitzdüse. Bevorzugt handelt es sich bei der Vorrichtung (4) um eine in der Breite verstellbare Schlitzdüse.

In einer bevorzugten Ausführungsform der Erfindung empfiehlt es sich, das schmelzflüssige Material in der Aufbringvorrichtung (4) in Bewegung zu halten, solange der Beschichtungsvorgang nicht läuft. Das schmelzflüssige Material kann beispielsweise in einem Kreislauf in Bewegung gehalten werden. Hierdurch lassen sich beispielsweise Anbackungen und Vernetzungsreaktionen während einer Unterbrechung der Beschichtung vermeiden. Zur Unterbrechung kann es insbesondere dann kommen, wenn nach vollständiger Beschichtung einer Hülse die beschichtete Hülse der Vorrichtung entnommen wird und eine neue, unbeschichtete Hülse für einen neuen Beschichtungsvorgang eingebaut wird.

Erfindungsgemäß umfasst das Verfahren mindestens die in den Ansprüchen beschriebenen und nachfolgenden Verfahrensschritte (A), (B) und (C). Es kann darüber hinaus noch weitere Verfahrensschritte umfassen.

In Verfahrensschritt (A) wird eine Schmelze eines reliefbildenden Materials bereitgestellt. Geeignete Zusammensetzungen reliefbildender Materialien wurden bereits oben genannt. Bevorzugt kann es sich um ein fotopolymerisierbares, reliefbildendes Material handeln. Die Schmelze kann in prinzipiell bekannter Art und Weise erhalten werden, indem man die Komponenten unter Erwärmen miteinander vermischt.
Das reliefbildende Material, bevorzugt das fotopolymerisierbare, reliefbildende Material kann in prinzipiell bekannter Art und Weise beispielsweise mittels eines Kneters, eines Einschneckenextruders oder eines Zweischneckenextruders gemischt und aufgeschmolzen werden. Die Schmelze kann optional entgast und zur Aufbringvorrichtung (4) gefördert werden.

In einer weiteren Ausführungsform von Verfahrensschritt (A) kann eine bereits in einem separaten Verfahrensschritt homogenisierte Mischung eines reliefbildenden Materials aufgeschmolzen und zur Aufbringvorrichtung (4) gefördert werden. Dies kann beispielsweise mittels einer beheizbaren Fasspumpe erfolgen.

In Verfahrensschritt (B) wird die auf die drehbare Haltevorrichtung (1) direkt oder indirekt montierte, zylindrische Hülse (3) mittels der Antriebseinheit der Vorrichtung (V) in Rotation um die Längsachse versetzt. Die Umdrehungsgeschwindigkeit richtet sich naturgemäß nach dem Umfang der Hülse. Die Oberflächengeschwindigkeit der Hülse beträgt üblicherweise 1 cm/s bis 10 cm/s.

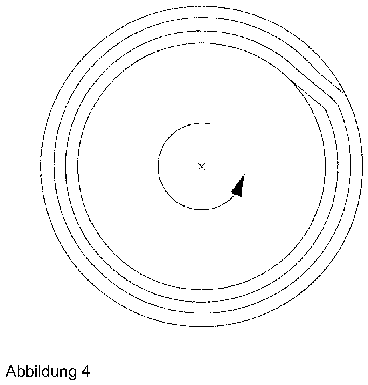

In Verfahrensschritt (C) wird mittels der Vorrichtung (4) das schmelzflüssige Material flächig auf die rotierende zylindrische Hülse (3) aufgetragen, d.h. es bildet sich eine Schicht des reliefbildenden Materials auf der Hülse (3) aus. Abbildung 1 zeigt die Situation schematisch nach einer halben Umdrehung der zylindrischen Hülse (3). Auf der Oberfläche der Hülse hat sich eine Schicht (5) des reliefbildenden Materials ausgebildet. Die Beschichtung der zylindrischen Hülse (3) erfolgt mit der Maßgabe, dass die zylindrische Hülse (3) während des Beschichtungsvorganges mindestens zwei vollständige Umdrehungen vollführt. Auf diese Art und Weise wird die Schicht des reliefbildenden Materials auf der Hülse aufgewickelt, und es werden somit mindestens zwei Schichten des reliefbildenden Materials aufeinander beschichtet. Die Beschichtung folgt einem schneckenförmigen Bewegungsablauf. Dies ist schematisch in Abbildung 4 dargestellt.

Bevorzugt vollführt die zylindrische Hülse (3) während des Beschichtungsvorganges mindestens drei vollständige Umdrehungen, so dass mindestens drei Schichten des fotopolymerisierbaren Materials aufeinander beschichtet werden. Die Zahl der Umdrehungen und damit die Zahl der übereinander abgelegten Schichten kann beispielsweise 3 bis 30 betragen, bevorzugt 5 bis 20.

Die Temperatur der Schmelze beim Aufbringen auf die zylindrische Hülse (3) richtet sich naturgemäß nach der Art des verwendeten reliefbildenden Materials, bevorzugt des fotopolymerisierbaren, reliefbildenden Materials sowie der gewünschten Viskosität der Schmelze und liegt üblicherweise zwischen 80°C und 160°C.

Der Abstand der Aufbringvorrichtung (4) zur zu beschichtenden zylindrischen Hülse (3) wird bevorzugt gering gehalten und sollte wenige mm nicht überschreiten. Er sollte in der Regel 0 mm bis 10 mm betragen, bevorzugt 0 mm bis 4 mm, z. B. 0,01 mm bis 4 mm. Ein Abstand von 0 mm bedeutet, dass die Aufbringvorrichtung (4) auch auf Kontakt herangefahren werden kann. Sie wirkt bei dieser Ausführungsform auch als Glättwerkzeug für die Schicht.

Es empfiehlt sich, den Abstand zwischen der Aufbringvorrichtung (4) und der jeweils letzten aufgebrachten Schicht des reliefbildenden Materials während des Beschichtens konstant zu halten, um gleichmäßige Beschichtungsbedingungen zu erreichen. Aufgrund des im Zuge der Beschichtung zunehmenden Durchmessers des zylindrischen Flexodruckelements empfiehlt es sich daher in einer bevorzugten Ausführungsform, den Abstand zwischen der Aufbringvorrichtung (4) und der zylindrischen Hülse (3) - ohne Beschichtung betrachtet - während des Beschichtungsvorganges entsprechend der zunehmenden Gesamtschichtdicke kontinuierlich zu erhöhen. Um eine Beschädigung der reliefbildenden Schicht zu vermeiden, sollte auf die Erhöhung des Abstandes besonders dann geachtet werden, wenn die Aufbringvorrichtung (4) auf Kontakt herangefahren wurde.

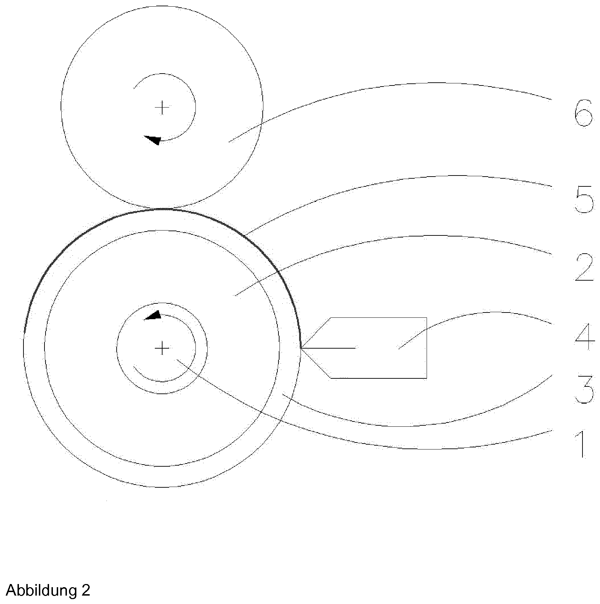

In einer bevorzugten Ausführungsform der Erfindung umfasst die Vorrichtung (V) weiterhin eine in Drehrichtung nach der Aufbringvorrichtung (4) angeordnete beheizbare Kalanderwalze (6). Diese Ausführungsform der Erfindung ist schematisch in Abbildung 2 gezeigt. Mit der Kalanderwalze (6) wird die soeben aufgebrachte Schicht (5) kalandriert. Der mit der Beschichtungswalze gleichlaufende Kalander wird üblicherweise auf Kontakt gefahren (Kissbeistellung) und fungiert in üblicher Art und Weise als Glättwerkzeug für die aufgebrachte Schicht. Nach dem Aufbringen aller gewünschten Schichten und dem Stopp der Beschichtung kann es empfehlenswert sein, den Kalander noch einige Zeit nachlaufen zu lassen, um eine optimale Glättwirkung zu erzielen. Die Kalanderwalze (6) ist in aller Regel so gelagert, dass deren Abstand zur zylindrischen Hülse (3) variiert werden kann. Analog zur Aufbringvorrichtung empfiehlt es sich, den Abstand zwischen der Kalanderwalze (6) und der zylindrischen Hülse (3) - ohne Beschichtung betrachtet - während des Beschichtungsvorganges entsprechend der zunehmenden Gesamtschichtdicke kontinuierlich zu erhöhen.

Die Kalanderwalze wird bevorzugt beheizt. Die Temperatur richtet sich nach der Art des verwendeten reliefbildenden, bevorzugt fotopolymerisierbaren Materials. Bevorzugt liegt die Temperatur der Kalanderwalze zwischen 70°C und 120°C.

Die Oberflächentemperatur der aufgebrachten Schicht sollte 80°C, bevorzugt 70°C und besonders bevorzugt 60°C nicht übersteigen, bevor die nächste Schicht auf die zuvor aufgebrachte Schicht aufgebracht wird. Naturgemäß kühlt die aufgebrachte Schicht nach dem Aufbringen nach und nach von selbst ab. Um eine schnellere Beschichtung zu gewährleisten, kann es daher empfehlenswert sein, die aufgebrachte Beschichtung - gegebenenfalls nach dem Kalandrieren - mittels geeigneter Vorrichtungen aktiv abzukühlen.

In einer weiteren bevorzugten Ausführungsform der Erfindung umfasst die Vorrichtung (V) daher weiterhin in Drehrichtung nach der Aufbringvorrichtung (4) und - sofern vorhanden - nach der Kalanderwalze (6) mindestens eine Kühlvorrichtung (7) zum Abkühlen der Schicht.

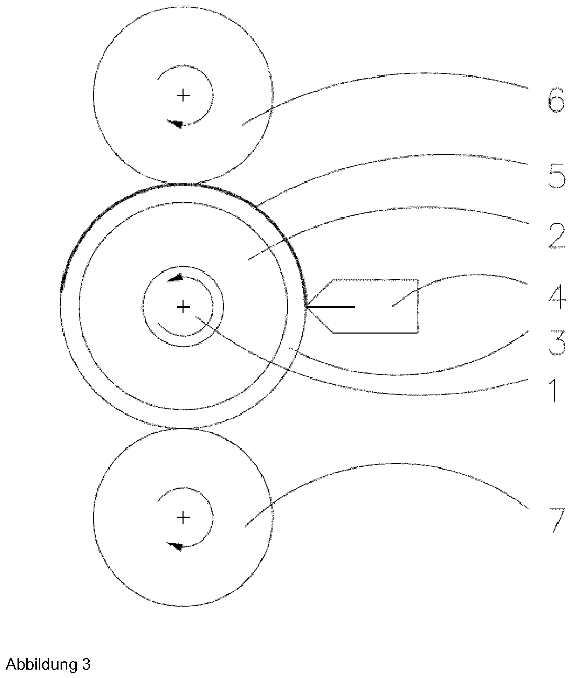

In einer Ausführungsform der Erfindung handelt es sich bei mindestens einer der Kühlvorrichtungen (7) um eine drehbar gelagerte, unbeheizte Walze. Eine derartige Ausführungsform der Erfindung ist schematisch in Abbildung 3 dargestellt. Es empfiehlt sich auch hier, den Abstand zwischen einer solchen Kühlwalze und der zylindrischen Hülse (3) -ohne Beschichtung betrachtet- während des Beschichtungsvorganges entsprechend der zunehmenden Gesamtschichtdicke kontinuierlich zu erhöhen.

In einer weiteren Ausführungsform der Erfindung handelt es sich bei mindestens einer der Kühlvorrichtungen (7) um eine Vorrichtung, mittels der ein Luftstrom auf die aufgebrachte Schicht geblasen werden kann. Es kann sich beispielsweise um Düsen handeln, mit denen Luft auf die Schicht geblasen werden kann.

Besonders vorteilhaft kann es sich um eine Ausführungsform der Erfindung handeln, bei der als Kühlvorrichtungen (7) mindestens eine drehbar gelagerte, unbeheizte Walze und eine Vorrichtung, mittels der ein Luftstrom auf die aufgebrachte Schicht geblasen werden kann, vorhandeln sind.

Die Dicke der aufgetragenen Einzelschichten reliefbildenden Materials beträgt in der Regel 0,05 mm bis 0,3 mm, bevorzugt 0,1 bis 0,25 mm.

Die Gesamtdicke der reliefbildenden Schicht beträgt in der Regel 0,3 mm bis 10 mm, oftmals 0,4 mm bis 10 mm.

Um eine besonders hohe Qualität der zylindrischen Flexodruckelemente zu gewährleisten, haben sich eine Reihe weiterer Maßnahmen bewährt.

In aller Regel empfiehlt es sich, die Drehzahl der zylindrischen Hülse während des Beschichtungsvorganges nicht zu verändern. In einer bevorzugten Ausführungsform der Erfindung hat es sich daher bewährt, die pro Zeiteinheit aufzubringende Menge des schmelzflüssigen, reliefbildenden Materials im Zuge der Beschichtung kontinuierlich zu erhöhen. Hiermit kann berücksichtigt werden, dass der Materialbedarf aufgrund des zunehmenden Durchmessers der beschichteten Hülse pro Umdrehung größer wird. Der Fachmann kann den Mehrbedarf pro Umdrehung leicht berechnen. Auf diese Art und Weise wird eine gleichmäßige Dicke der aufzubringenden Schichten gewährleistet und die Dickentoleranzen werden minimiert.

In einer weiteren bevorzugten Ausführungsform der Erfindung beginnt man die Beschichtung mit einer ansteigenden Rampe (der Materialfluss wird gesteigert) und beendet die Beschichtung mit einer absteigenden Rampe (der Materialfluss wird verringert). Auf diese Art und Weise wird beim Anfahren nicht sofort die gewünschte Schichtdicke erreicht, sondern man steigert die Schichtdicke langsam auf den gewünschten Wert, und beim Abfahren stoppt man die Beschichtung nicht abrupt, sondern die Schichtdicke wird langsam verringert. Die ansteigende Rampe und die absteigende Rampe sollten hierbei aufeinanderliegen. Auf diese Art und Weise lassen sich Schichtdickensprünge durch das An- und Abfahren kompensieren und die Dickentoleranzen des zylindrischen Flexodruckelements somit minimieren.

Abbildung 4 zeigt schematisch eine Seitenansicht einer beschichteten Hülse mit einer ansteigenden Rampe zu Beginn der Beschichtung und einer absteigenden Rampe am Ende der Beschichtung, wobei die auf- und die absteigende Rampe aufeinander liegen. Die Länge einer Rampe kann vom Fachmann bestimmt werden, bewährt hat sich etwa 1/30 bis 1/60 einer Umdrehung für die Rampe.

Mittels des beschriebenen Verfahrens lässt sich eine zylindrische Hülse (3) in ihrer gesamten Länge beschichten. Es ist selbstverständlich möglich, nicht die gesamte Länge zu beschichten, so dass an den Enden der Hülse unbeschichtete Bereiche verbleiben. Weiterhin ist es möglich, mehrere getrennte flächige Schichten auf die zylindrische Hülse aufzutragen. Hierdurch kann Material eingespart werden, beispielsweise, wenn separate Nutzen nebeneinander gedruckt werden sollen. Für letztere Ausführungsform ist als Aufbringvorrichtung (4) insbesondere eine Mehrkanaldüse geeignet, deren einzelne Kanäle jeweils separat geregelt werden.

In einer weiteren Ausführungsform der Erfindung kann man zwei oder mehrere schmelzflüssige Massen unterschiedlicher Zusammensetzung während der Beschichtung der zylindrischen Hülse aufbringen. Hierzu sollte eine Vorrichtung (V) eingesetzt werden, welche zwei oder mehrere Aufbringvorrichtungen (4) umfasst, wobei jede der Massen mittels einer bestimmten Aufbringvorrichtung aufgebracht wird. Auf diese Art und Weise lässt sich ein Flexodruckelement erhalten, welches mehrere unterschiedliche Schichten umfasst, bevorzugt zwei unterschiedliche Schichten. Der Begriff "Schicht" bezieht sich in diesem Zusammenhang auf den makroskopischen Aufbau des Flexodruckelements. Jede dieser Schichten kann durch Aufbringen mehrerer Einzelschichten mittels des erfindungsgemäßen Verfahrens erhalten werden. Der Wechsel von einem zum nächsten reliefbildenden, schmelzflüssigen Material kann prinzipiell jederzeit erfolgen, es ist aber bevorzugt, den Wechsel nur nach jeweils vollständigen Umdrehungen der Hülse vorzunehmen.

Die erfindungsgemäß verwendete Vorrichtung kann weiterhin zusätzliche Module enthalten, mit denen bereits aufgetragene Einzelschichten physikalisch modifiziert werden können. Auch somit kann ein Mehrschichtenaufbau erreicht werden.

Beispielsweise können bereits aufgebrachte fotopolymerisierbare Einzelschichten durch UV- oder UV/VIS-Strahlung (beispielsweise mittels UVA-LEDs) vernetzt werden. Die Bestrahlung kann bei weiterem Beschichten gestoppt werden. Auf diese Art und Weise lässt sich ein zylindrisches, fotopolymerisierbares Flexodruckelement erhalten, welches einen zweischichtigen Aufbau aus einer polymerisierten, elastomeren Unterschicht und einer fotopolymerisierbaren, reliefbildenden Oberschicht aufweist. Bei Verwendung eines solchen fotopolymerisierbaren Flexodruckelementes zur Herstellung von Flexodruckformen kann vorteilhaft auf die Rückseitenbelichtung verzichtet werden, welche bei zylindrischen, fotopolymerisierbaren Flexodruckelementen technisch schwierig ist.

In analoger Art und Weise kann auch mittels Elektronenstrahlung vernetzt werden, wobei die Anwendung von Elektronenstrahlung nicht auf fotopolymerisierbare Schichten beschränkt ist, sondern es können beispielsweise auch für UV/VIS-Strahlung opake Schichten mittels Elektronenstrahlung vernetzt werden.

Vor der Beschichtung mit dem reliefbildenden, schmelzflüssigen Material können auf die zylindrische Hülse (3) optional noch weitere Schichten aufgebracht werden, beispielsweise Klebe- oder Haftschichten. Derartige Schichten können in einem separaten Schritt aufgebracht worden, oder die erfindungsgemäß zu verwendende Vorrichtung kann zusätzliche Baueinheiten zum Aufbringen derartiger Schichten umfassen.

Überraschenderweise entstehen beim erfindungsgemäßen Verfahren beim Aufeinanderlegen der Schichten schmelzflüssigen, reliefbildenden Materials, bevorzugt des fotopolymerisierbaren Materials keinerlei Blasen oder andere Unregelmäßigkeiten. Auch das Anfahren oder Abfahren der Beschichtungsanlage hinterlässt keinerlei sichtbare Spuren im Endprodukt. Das erfindungsgemäße Verfahren liefert absolut fehlerfreie, toleranzgenaue zylindrische Flexodruckelemente mit hervorragender Oberfläche. Ein nachtägliches Schleifen oder Polieren der Oberfläche ist nicht notwendig.

### Aufbringung weiterer Schichten

Die erhaltenen, zylindrischen Flexodruckelemente können in weiteren Verfahrensschritten mit weiteren Schichten versehen werden. Fotopolymerisierbare, zylindrische Flexodruckelemente können insbesondere mit transparenten Deck- bzw. Barriereschichten und/oder laserablatierbaren Maskenschichten versehen werden. Geeignete Zusammensetzungen dieser Schichten wurden bereits eingangs erwähnt. Laserablatierbare Maskenschichten können beispielsweise in prinzipiell bekannter Art und Weise mittels Sprühcoaten oder Rollercoaten aufgebracht werden.

### Verarbeitung zu Flexodruckformen

Die mittels des Verfahrens erhaltenen, zylindrischen Flexodruckelemente können in prinzipiell bekannter Art und Weise zu Flexodruckformen weiterverarbeitet werden, die ebenfalls Gegenstand der Erfindung sind. Die Art der Weiterverarbeitung der Flexodruckelemente richtet sich nach der Art der reliefbildenden Schicht.

Bei zylindrischen fotopolymerisierbaren Flexodruckelemente, welche eine laserablatierbare Maskenschicht aufweisen, kann die Maskenschicht zunächst in prinzipiell bekannter Art und Weise mittels eines Lasers, insbesondere eines IR-Lasers, bebildert werden, d.h. die Maskenschicht wird an den Stellen, an denen sie vom Laserstrahl getroffen wird, abgetragen. Die fotopolymerisierbare Schicht kann anschließend mit aktinischem Licht, insbesondere UV- bzw. UV-VIS-Strahlung bildmäßig belichtet werden. Die Reste der Maskenschicht sowie die unbelichtet gebliebenen Teile der Schicht können anschließend auf geeignete Art und Weise entfernt werden. Dies kann beispielsweise durch Auswaschen unter Verwendung geeigneter Lösemittel oder Lösemittelmischungen erfolgen. Alternativ können die unbelichteten Anteile auch thermisch entfernt werden, indem man die Schicht mit einem saugfähigen Material, wie beispielsweise einem Vliesstoff in Kontakt bringt und die Schicht erwärmt. Die unter Temperatureinfluss erweichten Anteile der Schicht werden vom saugfähigen Material aufgesogen und können zusammen mit dem saugfähigen Material abgezogen werden. An das Entfernen der unbelichteten Anteile kann sich eine übliche Nachbehandlung, z.B. Bestrahlen mit UV-C-Licht anschließen. Man erhält schließlich eine zylinderförmige Flexodruckform, welche zum Drucken eingesetzt werden kann.

Fotopolymerisierbare Flexodruckelemente können auch mittels Lasergravur zu Flexodruckformen verarbeitet werden. Hierzu wird die fotopolymerisierbare, reliefbildende Schicht mit aktinischem Licht, insbesondere UV- bzw. UV-VIS-Strahlung nicht bildmäßig, sondern vollflächig belichtet. In die vollständig vernetzte Schicht kann anschließend mittels eines Lasers, insbesondere eines IR-Lasers ein Relief eingraviert werden.

Anstelle von UV- bzw. UV-VIS-Strahlung kann zur vollflächigen Vernetzung auch Elektronenstrahlung eingesetzt werden. Elektronenstrahlung kann zum Vernetzen auch vorteilhaft dann eingesetzt werden, wenn die reliefbildende Schicht keine ausreichende Transparenz für UV- bzw. UV/VIS-Strahlung mehr aufweist, beispielsweise aufgrund des Vorhandenseins von Ruß.

In mittels Füllstoffen mechanisch verstärkte Flexodruckelemente kann direkt nach der Herstellung ein Relief mittels Lasergravur eingraviert werden.

Mittels Lasergravur hergestellte Flexodruckelemente können optional mittels bekannter Methoden nachbehandelt werden. Beispielsweise kann die frisch gravierte Schicht mittels geeigneter flüssiger Reinigungsformulierungen nachbehandelt werden.

Die folgenden Beispiele sollen die Erfindung näher illustrieren:

### Bestimmung der Rundlaufgenauigkeit:

Die Rundlaufgenauigkeit wurde mit einem Keyence Lichtbandmikrometer bestimmt und ist ein Maß für die maximale Abweichung des Höhenprofils des Sleeves von der idealen Kreisform. Die Abweichungen von der Kreisform wurden an 5 Messstellen längs der beschichteten Hülse vermessen und die absolute Abweichung in µm ermittelt.

### Beispiel 1: Auftrag von 7 Schichten übereinander

Die zum Beschichten verwendete Apparatur umfasst einen von einer Antriebvorrichtung angetriebenen, drehbaren Kern. Die Apparatur umfasst als Aufbringvorrichtung eine 50 cm breite Mehrkanaldüse mit 20 separaten Kanälen, deren Durchfluss jeweils mittels einer Zahnradpumpe gesteuert werden kann. Ein einzelner Kanal weist eine Beschichtungsbreite von 25 mm auf. Die Düsen weisen weiterhin ein Anfahrventil auf, durch welches in die Düse gefördertes Material vor dem Anfahren beispielsweise zur Beurteilung der Qualität abgelassen werden kann. Weiterhin umfasst die Apparatur eine in Drehrichtung hinter der Mehrkanaldüse angeordnete Kalanderwalze.

Auf den Kern der Anlage wurde ein Stahladapter mit Durchmesser von 168,82 mm aufgezogen. Mittels Pressluft wurde auf den Stahladapter ein Basissleeve (rotec^{®} Photolight) mit einer Wandstärke von 0,68 mm, einem Außendurchmesser von 170,18 mm und einer Länge von 650 mm aufgezogen.

Zum Beschichten wurde ein fotopolymerisierbares Material der folgenden Zusammensetzung eingesetzt:

| | |
|---|---|
| Styrol-Butadien-Styrol Blockkautschuk (Kraton^{®} 1102) | 59 Teile |
| Hexandioldiacrylat | 10 Teile |
| Benzildimethylketal | 2 Teile |
| Stabilisator Kerobit TBK (Hersteller BASF) | 1 Teil |
| Polybutadienöle | 28 Teile |

Kraton^{®} 1102 ist ein handelsübliches, lineares S/B-Block-Copolymer (Hersteller Kraton Polymers). Die Komponenten wurden in einem Zweischneckenextruder ZSK 30 bei 130°C bis 150°C aufgeschmolzen, filtriert und entgast. Der Durchsatz des Extruders wurde so geregelt, dass für die Zahnradpumpen in der Düse ausreichend Material zur Verfügung stand.

Die Schmelzetemperatur in der Düse betrug 160°C. Erst nachdem die Schmelze aus dem Anfahrventil vor der Düse homogen austrat, wurde das Anfahrventil geschlossen und die Beschichtung begonnen. Düse und Kalander wurden in Position gefahren. Die Kalandertemperatur betrug 90°C. Die Beschichtung wurde mit einem Volumenfluss von 6,63 l/h begonnen und -wegen des zunehmenden Durchmessers- bis zum Beschichtungsende auf 6,72 l/h gesteigert. Die Umdrehungsgeschwindigkeit der Trägerwalze betrug 2,33 U/Minute. Die Dicke einer aufgetragenen Schicht betrug 177 µm. Die Gesamtbeschichtungsdauer betrug 3 Minuten. Die Gesamtauftragsdicke nach erfolgter Beschichtung betrug 1,24 mm (7 Schichten ä 177 µm). Für die Anfahr- und Abfahrrampe wurde eine Zeitspanne von 3 Sekunden eingestellt.

Während des Beschichtungsvorganges wurde jede einzelne Schicht kalandriert. Der Kalander wurde dabei jeweils in Kissprint-Beistellung gefahren. In Drehrichtung hinter der Kalanderwalze wurde die Schicht mit Luftdüsen angeblasen, bevor die nächste Schicht aufgetragen wurde. Nach Beschichtungsende wurde noch zusätzliche 2 Minuten geglättet und anschließend weitere 2 Minuten gekühlt.

Der beschichtete Sleeve wurde vom Adapter abgezogen und wies eine perfekte, gleichmäßige Oberfläche auf. Es waren keinerlei Blasen zu erkennen. Die Rundlaufgenauigkeit betrug 17 µm.

### Vergleichsbeispiel 1: Auftrag einer einzigen Schicht mit Spalt

Der Durchsatz des Extruders wurde gesteigert (25 kg/h), so dass ausreichend Schmelzematerial an der Düse zur Verfügung stand, um eine 1,24 mm dicke photopolymerisierbare Einzelschicht auf den Basissleeve aufzubringen. Die Schmelzetemperatur in der Düse betrug 163°C.

Die Abmessungen des Stahladapters und die Abmessung des Basissleeves waren wie in Beispiel 1.

Düse und Kalander wurden in Position gefahren. Die Beschichtung wurde mit einem Volumenfluss von 19,89 l/h begonnen. Die Umdrehungsgeschwindigkeit der Trägerwalze wurde auf 1 U/min reduziert. Die Beschichtung wurde so gesteuert, dass sich zwischen Beschichtungsanfang und Beschichtungsende ein ca. 1 mm großer Spalt befand.

Um den Spalt zu verschließen, wurde die Schicht direkt nach Auftrag kalandriert (ohne Kühlung mit Luft). Die Temperatur des Kalanders betrug 120°C. Der Kalander wurde mit einer Druckbeistellung von 60 µm gefahren. Nach einer Kalandrierdauer von 10 Minuten war der Spalt makroskopisch verschlossen.

Der beschichtete Sleeve wurde abgekühlt und abgezogen. Der Spalt war zwar verschlossen. Es waren aber zahlreiche Luftblasen (38 Blasen) im Spalt eingeschlossen. Die Rundlaufgenauigkeit war ungenügend. Sie betrug 63 µm.

### Vergleichsbeispiel 2: Auftrag einer einzigen Schicht ohne Spalt

Das Vergleichsbeispiel wurde wiederholt. Der Auftrag der Schicht wurde wiederum mit einer Durchflussmenge von 19,89 l/h bei einer Umdrehungsgeschwindigkeit von 1 U/min begonnen. Zur Vermeidung eines Spaltes wurde die Beschichtung mit einer 3 Sekunden währenden Anfahrrampe und Abfahrrampe begonnen bzw. beendet. Die Schichtdicke der Schicht betrug wiederum 1,24 mm.

Direkt nach Auftrag wurde die Schicht kalandriert. Der Kalander wurde mit einer Beistellung von 30 µm gefahren. Die Kalandertemperatur betrug 90°C. Nach 5 Minuten Kalandrieren wurde der Sleeve abgezogen. Die Oberfläche war einwandfrei und wies keinerlei Blasen auf. Allerdings war die Rundlaufgenauigkeit ungenügend. Sie betrug 45 µm.

## Patentansprüche

1. Verfahren zur Herstellung von zylindrischen Flexodruckelementen, mindestens umfassend eine zylindrische Hülse (3) sowie eine reliefbildende Schicht, **dadurch gekennzeichnet, dass** man zum Aufbringen der reliefbildenden Schicht eine Vorrichtung (V) verwendet, welche mindestens die folgenden Komponenten umfasst:
• eine Haltevorrichtung (1) zur drehbaren Lagerung der zylindrischen Hülse (3),
• eine Antriebeinheit, mit der die zylindrische Hülse (3) in Rotation um die Längsachse versetzt werden kann,
• eine Aufbringvorrichtung (4) zum flächigen Auftragen eines schmelzflüssigen, reliefbildenden Materials auf die zylindrische Hülse (3),
und dass das Verfahren mindestens die folgenden Verfahrensschritte umfasst:
(A) Bereitstellen einer Schmelze eines reliefbildenden Materials,
(B) Versetzen der zylindrischen Hülse (3) in Rotation um die Längsachse,
(C) flächiges Auftragen des schmelzflüssigen, reliefbildenden Materials auf die rotierende zylindrische Hülse (3) mittels der Vorrichtung (4), wobei sich eine Schicht des reliefbildenden Materials auf der zylindrischen Hülse (3) bildet, mit der Maßgabe, dass die zylindrische Hülse während des Beschichtungsvorganges mindestens zwei vollständige Umdrehungen vollführt, so dass mindestens zwei Schichten des reliefbildenden Materials aufeinander beschichtet werden, wobei der Abstand der Vorrichtung (4) und der jeweils letzten aufgebrachten Schicht des reliefbildenden Materials während des Beschichtens konstant gehalten wird und somit entsprechend der zunehmenden Gesamtschichtdicke der Abstand zwischen der Vorrichtung (4) und der zylindrischen Hülse (3) erhöht wird.

2. Verfahren gemäß Anspruch 1, **dadurch gekennzeichnet, dass** die Vorrichtung (V) weiterhin eine in Drehrichtung nach der Aufbringvorrichtung (4) angeordnete beheizbare Kalanderwalze (6) umfasst, und man die aufgebrachte Schicht kalandriert.

3. Verfahren gemäß Anspruch 1 oder 2, **dadurch gekennzeichnet, dass** die Vorrichtung (V) weiterhin in Drehrichtung nach der Aufbringvorrichtung (4) und -sofern vorhanden- nach der Kalanderwalze (6) mindestens eine Kühlvorrichtung (7) zum Abkühlen der Schicht umfasst.

4. Verfahren gemäß Anspruch 3, **dadurch gekennzeichnet, dass** es sich bei mindestens einer der Kühlvorrichtungen (7) um eine Vorrichtung handelt, mittels der ein Luftstrom auf die aufgebrachte Schicht geblasen werden kann.

5. Verfahren gemäß Anspruch 3 oder 4, **dadurch gekennzeichnet, dass** es sich bei mindestens einer der Kühlvorrichtungen (7) um eine drehbare gelagerte, unbeheizte Walze handelt.

6. Verfahren gemäß einem der Ansprüche 1 bis 5, **dadurch gekennzeichnet, dass** es sich bei der Auftragsvorrichtung (4) um eine in der Breite verstellbare Schlitzdüse handelt.

7. Verfahren gemäß einem der Ansprüche 1 bis 6, **dadurch gekennzeichnet, dass** die Dicke der aufgetragenen Einzelschichten reliefbildenden Materials 0,05 mm bis 0,3 mm beträgt.

8. Verfahren gemäß einem der Ansprüche 1 bis 7, **dadurch gekennzeichnet**, das die Gesamtdicke der reliefbildenden Schicht 0,3 mm bis 10 mm beträgt.

9. Verfahren gemäß einem der Ansprüche 1 bis 8, **dadurch gekennzeichnet, dass** Schritt (A) durchgeführt wird, indem die Komponenten der reliefbildenden Schicht unter Verwendung eines Extruders oder Kneters gemischt und aufgeschmolzen werden, die Schmelze optional entgast und zur Auftragsvorrichtung (4) gefördert wird.

10. Verfahren gemäß einem der Ansprüche 1 bis 9, **dadurch gekennzeichnet, dass** die zylindrische Basishülse während des Beschichtungsvorganges mindestens drei vollständige Umdrehungen vollführt, so dass mindestens 3 Schichten des reliefbildenden Materials aufeinander beschichtet werden.

11. Verfahren gemäß einem der Ansprüche 1 bis 10, **dadurch gekennzeichnet, dass** man nacheinander mindestens zwei unterschiedliche, schmelzflüssige Materialien aufbringt.

12. Verfahren gemäß einem der Ansprüche 1 bis 11, **dadurch gekennzeichnet, dass** es sich bei der reliefbildenden Schicht um eine fotopolymerisierbare, reliefbildende Schicht handelt und man im Zuge des Verfahrens ein schmelzflüssiges, fotopolymerisierbares Material aufträgt.

13. Verfahren gemäß einem der Ansprüche 1 bis 12, **dadurch gekennzeichnet, dass** man vor dem Aufbringen der reliefbildenden Schicht auf die zylindrische Hülse (3) zunächst eine Haft-, Klebe-, Schaumschicht oder eine elastomere Unterschicht aufträgt.

14. Verfahren gemäß einem der Ansprüche 1 bis 13, **dadurch gekennzeichnet, dass** die Vorrichtung (V) zusätzliche Module umfasst, mit denen bereits aufgetragene Schichten physikalisch modifiziert werden können.

15. Verfahren gemäß Anspruch 14, **dadurch gekennzeichnet, dass** es sich bei dem zusätzlichen Modul um eine Vorrichtung zum Bestrahlen aufgebrachter Schichten mit Elektronenstrahlung handelt und man bereits aufgebrachte reliefbildende Schichten vollflächig vernetzt.

16. Verfahren gemäß Anspruch 14, **dadurch gekennzeichnet, dass** es sich bei dem zusätzlichen Modul um eine Vorrichtung zum Bestrahlen aufgebrachter Schichten mit UV- oder UV/VIS-Strahlung handelt und man bereits aufgebrachte fotopolymerisierbare Schichten vollflächig vernetzt.

17. Verfahren gemäß einem der Ansprüche 12 bis 16, **dadurch gekennzeichnet, dass** man nach dem Aufbringen einer fotopolymerisierbaren, reliefbildenden Schicht in einem weiteren Verfahrensschritt zusätzlich eine transparente Deck- oder Barriereschicht auf die fotopolymerisierbare, reliefbildende Schicht aufbringt.

18. Verfahren gemäß einem der Ansprüche 12 bis 17, **dadurch gekennzeichnet, dass** man nach dem Aufbringen einer fotopolymerisierbaren, reliefbildenden Schicht in einem weiteren Verfahrensschritt eine laserablatierbare Maskenschicht auf die fotopolymerisierbare, reliefbildenden Schicht oder -sofern vorhanden- auf die transparente Deck- oder Barriereschicht aufbringt.

## Claims

1. Method for producing cylindrical flexographic printing elements at least comprising a cylindrical sleeve (3) and also a relief-forming layer, **characterized in that** the relief-forming layer is applied using an apparatus (V) which comprises at least the following components:
• a mounting means (1) for rotatable mounting of the cylindrical sleeve (3),
• a drive unit which allows the cylindrical sleeve (3) to be rotated about the longitudinal axis,
• an application means (4) for areal application of a relief-forming material in liquid melt form to the cylindrical sleeve (3),
and **in that** the method comprises at least the following method steps:
(A) providing a melt of a relief-forming material,
(B) rotating the cylindrical sleeve (3) about the longitudinal axis,
(C) areally applying the relief-forming material in liquid melt form to the rotating cylindrical sleeve (3) by means of the means (4), with a layer of the relief-forming material forming on the cylindrical sleeve (3), with the proviso that during the coating operation the cylindrical sleeve completes at least two complete rotations, so that at least two layers of the relief-forming material are coated one onto the other, the distance between the means (4) and the most recently applied layer of the relief-forming material being kept constant during coating and therefore the distance between the means (4) and the cylindrical sleeve (3) being increased in accordance with the increasing total layer thickness.

2. Method according to Claim 1, **characterized in that** the apparatus (V) further comprises a heatable calender roll (6), disposed downstream of the application means (4) in the direction of rotation, and the applied layer is calendered.

3. Method according to Claim 1 or 2, **characterized in that** the apparatus (V) further comprises at least one cooling means (7) for cooling the layer, disposed downstream of the application means (4) and - where present - of the calender roll (6) in the direction of rotation.

4. Method according to Claim 3, **characterized in that** at least one of the cooling means (7) is a means by which a stream of air can be blown onto the applied layer.

5. Method according to Claim 3 or 4, **characterized in that** at least one of the cooling means (7) is a rotatable mounted, unheated roll.

6. Method according to any of Claims 1 to 5, **characterized in that** the application means (4) is a slot die adjustable in width.

7. Method according to any of Claims 1 to 6, **characterized in that** the thickness of the applied single layers of relief-forming material is 0.05 mm to 0.3 mm.

8. Method according to any of Claims 1 to 7, **characterized in that** the total thickness of the relief-forming layer is 0.3 mm to 10 mm.

9. Method according to any of Claims 1 to 8, **characterized in that** step (A) is performed by mixing the components of the relief-forming layer using an extruder or compounder and melting the mixture, the melt being optionally degassed and conveyed to the application means (4).

10. Method according to any of Claims 1 to 9, **characterized in that** during the coating operation the cylindrical base sleeve completes at least three complete rotations, so that at least 3 layers of the relief-forming material are coated one onto another.

11. Method according to any of Claims 1 to 10, **characterized in that** at least two different materials in liquid melt form are applied in succession.

12. Method according to any of Claims 1 to 11, **characterized in that** the relief-forming layer is a photopolymerizable relief-forming layer and in the course of the method a photopolymerizable material in liquid melt form is applied.

13. Method according to any of Claims 1 to 12, **characterized in that** application of the relief-forming layer is preceded by application to the cylindrical sleeve (3) first of a tie, a bond, or foam layer or of an elastomeric underlayer.

14. Method according to any of Claims 1 to 13, **characterized in that** the apparatus (V) comprises additional modules with which layers already applied can be physically modified.

15. Method according to Claim 14, **characterized in that** the additional module is a means for irradiating applied layers with electron beams, and relief-forming layers already applied are subjected to full-area crosslinking.

16. Method according to Claim 14, **characterized in that** the additional module is a means for irradiating applied layers with UV or UV/VIS radiation, and photopolymerizable layers already applied are subjected to full-area crosslinking.

17. Method according to any of Claims 12 to 16, **characterized in that** application of a photopolymerizable, relief-forming layer is followed in a further method step by application additionally of a transparent outer layer or barrier layer to the photopolymerizable, relief-forming layer.

18. Method according to any of Claims 12 to 17, **characterized in that** application of a photopolymerizable, relief-forming layer is followed in a further method step by application of a laser-ablatable mask layer to the photopolymerizable, relief-forming layer or - where present - to the transparent outer layer or barrier layer.

## Revendications

1. Procédé de fabrication d'éléments d'impression flexographique cylindriques, comprenant au moins un manchon cylindrique (3) ainsi qu'une couche de formation de relief, **caractérisé en ce que** l'on utilise pour le dépôt de la couche de formation de relief un dispositif (V), qui comprend au moins les composants suivants:
• un dispositif de maintien (1) pour le support rotatif du manchon cylindrique (3),
• une unité d'entraînement, avec laquelle le manchon cylindrique (3) peut être mis en rotation autour de l'axe longitudinal,
• un dispositif de dépôt (4) pour le dépôt plat d'une matière liquide fondue formant un relief sur le manchon cylindrique (3),
et **en ce que** le procédé comprend au moins les étapes de procédé suivantes:
(A) préparer un bain fondu d'une matière de formation de relief,
(B) mettre le manchon cylindrique (3) en rotation autour de l'axe longitudinal,
(C) déposer à plat la matière liquide fondue de formation de relief sur le manchon cylindrique en rotation (3) au moyen du dispositif (4), dans lequel il se forme une couche de la matière de formation de relief sur le manchon cylindrique (3), avec la condition que le manchon cylindrique accomplisse au moins deux révolutions complètes pendant l'opération de revêtement, de telle manière qu'au moins deux couches de la matière de formation de relief soient déposées l'une sur l'autre, dans lequel on maintient constante la distance entre le dispositif (4) et la dernière couche respectivement déposée de la matière de formation de relief pendant le revêtement et on augmente ainsi la distance entre le dispositif (4) et le manchon cylindrique (3) en fonction de l'augmentation de l'épaisseur de couche totale.

2. Procédé selon la revendication 1, **caractérisé en ce que** le dispositif (V) comprend en outre un rouleau de calandre chauffant (6) disposé dans le sens de rotation après le dispositif de dépôt (4), et on calandre la couche déposée.

3. Procédé selon la revendication 1 ou 2, **caractérisé en ce que** le dispositif (V) comprend en outre au moins un dispositif de refroidissement (7), disposé dans le sens de rotation après le dispositif de dépôt (4) et - dans la mesure où il est présent - après le rouleau de calandre (6), pour le refroidissement de la couche.

4. Procédé selon la revendication 3, **caractérisé en ce qu'**au moins un des dispositifs de refroidissement (7) est un dispositif, au moyen duquel un courant d'air peut être soufflé sur la couche déposée.

5. Procédé selon la revendication 3 ou 4, **caractérisé en ce qu'**au moins un des dispositifs de refroidissement (7) est un rouleau non chauffé, supporté de façon rotative.

6. Procédé selon l'une quelconque des revendications 1 à 5, **caractérisé en ce que** le dispositif de dépôt (4) est une buse fendue de largeur réglable.

7. Procédé selon l'une quelconque des revendications 1 à 6, **caractérisé en ce que** l'épaisseur des couches individuelles déposées de matière de formation de relief vaut 0,05 mm à 0,3 mm.

8. Procédé selon l'une quelconque des revendications 1 à 7, **caractérisé en ce que** l'épaisseur totale de la couche de formation de relief vaut 0,3 mm à 10 mm.

9. Procédé selon l'une quelconque des revendications 1 à 8, **caractérisé en ce que** l'on exécute l'étape (A) en mélangeant et en fondant les composants de la couche de formation de relief en utilisant une extrudeuse ou un malaxeur, on dégaze optionnellement le bain fondu et on l'envoie au dispositif de dépôt (4).

10. Procédé selon l'une quelconque des revendications 1 à 9, **caractérisé en ce que** le manchon cylindrique de base accomplit pendant l'opération de revêtement au moins trois révolutions complètes, de telle manière qu'au moins 3 couches de la matière de formation de relief soient déposées l'une sur l'autre.

11. Procédé selon l'une quelconque des revendications 1 à 10, **caractérisé en ce que** l'on dépose l'une après l'autre au moins deux matières fondues liquides différentes.

12. Procédé selon l'une quelconque des revendications 1 à 11, **caractérisé en ce que** la couche de formation de relief est une couche de formation de relief photopolymérisable et on dépose au cours du procédé une matière fondue liquide photopolymérisable.

13. Procédé selon l'une quelconque des revendications 1 à 12, **caractérisé en ce que** l'on dépose d'abord une sous-couche d'accrochage, de collage, de mousse ou élastomère sur le manchon cylindrique (3) avant le dépôt de la couche de formation de relief.

14. Procédé selon l'une quelconque des revendications 1 à 13, **caractérisé en ce que** le dispositif (V) comprend des modules supplémentaires, avec lesquels des couches déjà déposées peuvent être physiquement modifiées.

15. Procédé selon la revendication 14, **caractérisé en ce que** le module supplémentaire est un dispositif pour irradier des couches déposées avec un faisceau d'électrons et on réticule sur toute la surface des couches de formation de relief déjà déposées.

16. Procédé selon la revendication 14, **caractérisé en ce que** le module supplémentaire est un dispositif pour irradier des couches déposées avec un rayonnement UV ou UV/VIS et on réticule sur toute la surface des couches photopolymérisables déjà déposées.

17. Procédé selon l'une quelconque des revendications 12 à 16, **caractérisé en ce que** l'on dépose en outre, dans une autre étape de procédé, une couche de recouvrement ou de barrière transparente sur la couche de formation de relief photopolymérisable après le dépôt d'une couche de formation de relief photopolymérisable.

18. Procédé selon l'une quelconque des revendications 12 à 17, **caractérisé en ce que** l'on dépose dans une autre étape de procédé, après le dépôt d'une couche de formation de relief photopolymérisable, une couche de masquage ablatable au laser sur la couche de formation de relief photopolymérisable ou - dans la mesure où elle est présente - sur la couche de recouvrement ou de barrière transparente.
